# EUROPEAN PATENT APPLICATION

(11) **EP 4 815 315 A1**
(43) Date of publication of application: **30.09.2026**
(21) Application number: 26162522.2
(22) Date of filing: 05.03.2026
(51) Int. Cl.: H03M 1/46, H03M 1/12, H03M 1/14

(54) **SUCCESSIVE APPROXIMATION REGISTER ANALOG TO DIGITAL CONVERTER AND CORRESPONDING METHOD OF CONVERSION**

(30) Priority: 26.03.2025 IT 202500006177
(71) Applicant: STMicroelectronics International N.V., 1228 Plan-les-Ouates, Geneva (CH)
(72) Inventor: D'ANGELO, Giuseppe, I-80030 Tufino (Napoli) (IT)
(74) Representative: Buzzi, Notaro & Antonielli d'Oulx S.p.A.

(57) **Abstract**

A Successive Approximation Register Analog to Digital Converter architecture (50; 60; 70; 80) comprising
at least an input sample and-hold circuit (10; 19; 28; 38₁, 38₂) receiving an analog input voltage (V_{IN1}; V_{IN1}, V_{IN2}) and
a control logic with a data register (15; 25; 35; 45₁, 45₂) configured to generate a digital output value (VDₒᵤₜ; VDₒᵤₜ₁, VDₒᵤₜ₂) with a given maximum bit length (M+N; M1+M2) depending on the value of a comparator (14; 24; 34; 44₁, 44₂) which input is selectably coupled to said analog input voltage (V_{IN1}; V_{IN1}, V_{IN2}) through a multiplexer (13; 23; 33; 43₁, 43₂) together with an analog output (V_{DAC}) of a digital to analog converter (16; 26; 36; 46₁, 46₂) operating with a number of input bits (N) lower than said given maximum bit length (M+N; M1+M2), which input is set by said control logic with a data register (15; 25; 35; 45₁, 45₂), said architecture (50; 60; 70; 80) further comprising a differential stage (11; 20; 29; 47) performing a difference between said analog input voltage (V_{IN1}; V_{IN1}, V_{IN2}) and said analog output (V_{DAC}) which output is also selectably coupled to said comparator (14; 24; 34; 44₁, 44₂) through said multiplexer (13; 23; 33; 43₁, 43₂), wherein
a further sample-and-hold circuit (21; 32; 49) is interposed between said differential stage (20; 29; 47) and said multiplexer (13; 23; 33; 43₁, 43₂), said control logic with a data register (15; 25; 35; 45₁, 45₂) being configured to operate at least in a first operation mode in which couples said comparator (24; 34; 44₁, 44₂)
in a first phase to said input sample and hold circuit (19; 28; 38₁, 38₂) performing a binary search to obtain first most significant bits (M; M1) of said digital output value (VDₒᵤₜ), and
in a second phase to said further sample-and-hold circuit (21; 31, 39) performing a binary search to obtain the remaining bits (N; M2) of said digital output value (VDₒᵤₜ; VDₒᵤₜ₁, VDₒᵤₜ₂).

## Description

### Technical field

The description relates to techniques for Successive Approximation Register Analog to Digital Conversion, with high resolution, comprising a sample and hold circuit receiving an input analog voltage, a control logic with data register to generate digital values depending on the output of a comparator which compares the input analog voltage to a feedback analog signal obtained controlled by the control logic.

The solution may be applied in the field of Automotive applications, such as High-end Drivetrain & Power Conversion, Body/Gateway applications, Electrification (Traction, OBC, BMS)

### Technological background

There are many different implementations of an analog to digital converter (ADC), which can obtain a high resolution of conversion.

Among the type of converters suitable to obtain high resolution of conversion, a Successive-Approximation (SAR) ADC is then a type of ADC that converts a continuous analog waveform into a discrete digital representation using a binary search algorithm converging upon a representative binary code for each conversion.

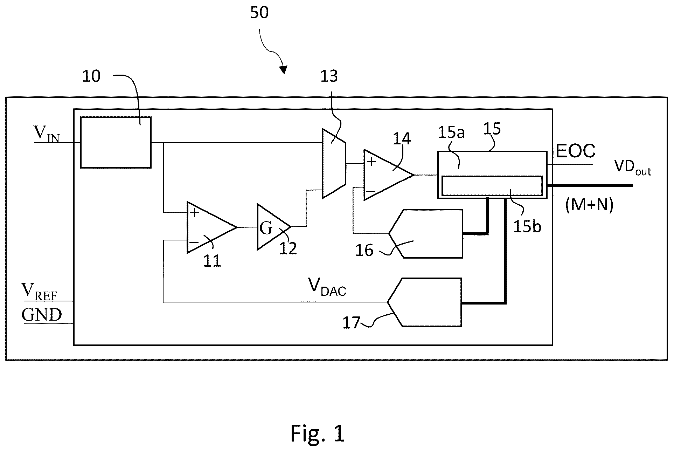

In Figure 1 by way of example it is shown by a schematic diagram an embodiment of a Successive Approximation Register Analog-to-Digital Converter (SAR ADC) 50 according to the prior art. The system comprises multiple interconnected functional blocks designed to sample, process, and convert an analog input signal into a corresponding digital output.

The ADC 50 receives an input voltage signal V_{IN}, as well as a reference voltage V_{REF} and a ground potential GND. A sample-and-hold (sample-and-hold) circuit 10 initially samples and temporarily holds the analog input voltage signal V_{IN}. The voltage stored in the sample-and-hold circuit 10 is then forwarded to a differential block 11, which operates a voltage subtraction of its inputs, where it is processed to compute the difference relative to an analog feedback signal V_{DAC}, at the output of a digital-to-analog conversion stage, second DAC 17, with M-bit resolution, as explained below.

Thus, the output of the differential block 11 is fed into a gain stage 12, which amplifies the signal by a predetermined gain factor. The amplified signal at the output of the gain stage 12 is then directed into a multiplexer 13, which selects an appropriate signal path at its output based on control inputs. The output of the multiplexer 13 is then processed by a comparator 14, which compares the selected signal at the output of the multiplexer 13 and a value from a first DAC 16 with N-bit resolution.

A control logic and data register module 15, i.e., a module comprising a control logic 15a, e.g. a microprocessor or a logic circuit, and a data register 15b configured to store data, namely the bit of the digital value output, VDₒᵤₜ, by the ADC 50 as digital conversion of the analog input voltage signal V_{IN}, receives the output of the second differential block and is configure to command the successive approximation process and interfaces with digital-to-analog converters (DACs). In particular, in the example, two DACs are employed, the first DAC 16 with N-bit resolution, and the second DAC 17 with M-bit resolution.

As mentioned above, the outputs of both DACs 16 and 17 contribute to a respective feedback signal, i.e., are sent respectively to the comparator 11, and differential block 14, which is used in the approximation process to refine the conversion result. The system continues iterating through successive approximation cycles until the digital output converges to the final value.

Upon completion of the conversion, an End of Conversion signal EOC is generated by the control logic and data register 15, signalling that the final digital output, i.e. final value of VDₒᵤₜ, is available. The digital result is stored in the data register 15a, which produces an output digital converted value VDₒᵤₜ of (M+N) bits, combining the contributions from both DACs.

Thus, the analog input voltage V_{IN} is held by the sample-and-hold block 10 and a binary search algorithm, is implemented by the control logic and data register module 15 by setting, for instance the M-bits in the data register 15b, i.e., the M bits of the output digital value from the MSB, to a midscale value, e.g., 100...00b, to force the DAC 17 output, which is the analog voltage V_{DAC}, to V_{REF}/2, the reference voltage V_{REF} being supplied to the DAC 17 as reference value for the conversion. A comparison by an analog comparator, i.e., block 11, is then performed to determine if the input voltage V_{IN} is less than, or greater than, the DAC output V_{DAC}. If the analog input voltage V_{IN} is greater than DAC output V_{DAC}, the comparator 11 output assumes a logic high value, which is transmitted through the multiplexer 13, and the MSB of the digital output value in the register 15b remains at logic 1, otherwise it is cleared to logic 0. The SAR ADC control logic 15a then moves to the next step, forces the next bit high in the register 15b, and makes another comparison through modules 17 and 11, until the last of the first most significant M bits is set. Then, the N less significant bits are set with an analogous process by the internal loop of DAC 16 and differential block 14, always with respect to the analog input voltage V_{IN} which is selected by the multiplexer 14 in place of the output of the gain stage 12. The sequence continues until the value of the N LSB is determined. Once this is performed, the conversion is complete, the M+N bits binary code is available as output digital value VDₒᵤₜ in the relevant data register 15b of the control logic and data register module 15 and the End-Of-Conversion signal EOC is asserted, to indicate that the digital value VDₒᵤₜ is valid.

The architecture of figure 1 uses two steps for the MSB and LSB bits although in general a SAR ADC may have only one loop with a DAC and a differential block, which performs the binary search as described, i.e., by maintaining or clearing the bit sequentially depending from the result of the comparison to the input voltage.

This architecture enables efficient and precise analog-to-digital conversion with enhanced resolution and accuracy. The inclusion of dual DACs facilitates extended dynamic range and improved performance for applications requiring high-speed and high-resolution data acquisition.

A problem to solve is to increase the resolution of an ADC without excessively increasing its complexity or processing time.

As a further aspect, the request for a higher resolution is generally combined with the request to detect potential failures affecting the correctness of the digitized data for functional safety purposes. In order to detect these potential failures either it is assumed that each analog signal is converted sequentially more than one time using one ADC and each digitized data is compared with the other ones; or it is assumed that each analog signal is converted using two ADCs in parallel and the first digitized data is compared with the other one. The first method, with sequential conversion, has a poor diagnostic coverage because each analog signal is converted sequentially and the digitized data does not represent the same value. The second method with parallel conversion has a significant impact on the area because requires two independent ADCs.

### Object and summary

An object of one or more embodiments is to contribute in dealing with a number of issues which are recognized to exist in a context as discussed in the foregoing.

According to one or more embodiments that object may be achieved by means of a Successive Approximation Register Analog to Digital Converter architecture having the features set forth in the claims that follow.

One or more embodiments may relate to a corresponding for performing Successive Approximation Register Analog to Digital conversion.

As mentioned previously, various embodiments of the present disclosure regard a Successive Approximation Register Analog to Digital Converter architecture comprising at least an input sample and-hold circuit receiving an analog input voltage and a control logic with a data register configured to generate a digital output value with a given maximum bit length depending on the value of a comparator which input is selectably coupled to said analog input voltage through a multiplexer together with an analog output of a digital to analog converter operating with a number of input bits lower than said given maximum bit length, which input is set by said control logic with a data register, said architecture further comprising a differential stage performing a difference between said analog input voltage and said analog output which output is also selectably coupled to said comparator through said multiplexer, wherein
a further sample-and-hold circuit is interposed between said differential stage and said multiplexer, said control logic with a data register being configured to operate at least in a first operation mode in which couples said comparator,
in a first phase to said input sample and hold circuit performing a binary search to obtain first most significant bits of said digital output value, and
in a second phase to said further sample-and-hold circuit performing a binary search to obtain the remaining bits of said digital output value.

In variant embodiments said architecture receives a first input voltage in said sample-and-hold circuit and a second input voltage in a second multiplexer, which also has an input coupled to the output of said differential stage selectably coupling its inputs to said further sample-and-hold circuit under the control of said control logic with a data register.

In variant embodiments said control logic with a data register is configured to operate in said first operation mode or to operate in a second mode in which couples said comparator in a first phase to said input sample and hold circuit performing a binary search to obtain said digital output value of said first input voltage with a bit length corresponding to said number of input bits of said digital to analog converter, and in a second phase couples through said second multiplexer said second input voltage to said comparator through said multiplexer performing a binary search to obtain said digital output value of said second input voltage with a bit length corresponding to said number of input bits of said digital to analog converter.

In variant embodiments said architecture comprises two parallel branches , each comprising an input sample and-hold circuit receiving a respective analog input voltage and a control logic with a data register configured to generate a digital output value depending on the value of a respective comparator which input is selectably coupled to said respective analog input voltage through a respective multiplexer together with an analog output of a respective digital to analog converter which input is set by said respective control logic with a data register ,
said architecture further comprising a third multiplexer receiving the outputs of the sample-and-hold of said first branch and sample-and-hold of said second branch which output is coupled to said differential stage operating as voltage subtractor, which through a gain stage 48 feeds a third sample-and-hold 49 which output is fed to another input of the multiplexers of the first branch and second branch , and a fourth multiplexer selecting between the outputs of the digital to analog converter of the first branch and second branch respectively and feeding its selected value to the other input of the differential stage.

In variant embodiments said respective control logic with a data register are configured to operate in said first phase of said first mode of operation in parallel to determine respective first most significant bits of said respective digital output value at the output of said first branch and second branch , then in said second phase, in which said third multiplexer and fourth multiplexer selects first said first input voltage and analog output of the digital to analog converter of the first branch as inputs of said differential stage , then performing a binary search to obtain the remaining bits of said digital output value of said first branch , then said third multiplexer and fourth multiplexer selects second input voltage and analog output of the digital to analog converter of the second branch as inputs of said differential stage , then performing a binary search to obtain the remaining bits of said digital output value of said second branch .

In variant embodiments said digital to analog converter operates with a number of bits equal to the number of said less significant bits and a gain stage is coupled to said differential stage and said multiplexer, which has a gain of two to the power of the number of said most significant bits.

The solution here described in embodiments regards also a method for performing Successive Approximation Register Analog to Digital conversion with the architecture of any of claims 1 to 6, comprising at least a first mode of operation comprising a first phase comprising coupling said comparator to said input sample and hold circuit performing a binary search to obtain first most significant bits of said digital output value and in a second phase to said further sample-and-hold circuit performing a binary search to obtain the remaining bits of said digital output value .

In variant embodiments comprising operating in said first operation mode or to operate in a second mode comprising coupling said comparator in a first phase to said input sample and hold circuit performing a binary search to obtain said digital output value of said first input voltage with a bit length corresponding to said number of input bits of said digital to analog converter and in a second phase comprising coupling through said second multiplexer said second input voltage to said comparator through said multiplexer performing a binary search to obtain said digital output value of said second input voltage with a bit length corresponding to said number of input bits of said digital to analog converter.

In variant embodiments comprising operating in said first phase of said first mode of operation in parallel to determine respective first most significant bits of said respective digital output value at the output of said first branch and second branch , then in said second phase of said first mode of operation by selecting through said third multiplexer and fourth multiplexer first said first input voltage and analog output of the digital to analog converter of the first branch ) as inputs of said differential stage , performing then a binary search to obtain the remaining bits of said digital output value of said first branch , then selecting through said third multiplexer and fourth multiplexer the second input voltage and analog output of the digital to analog converter of the second branch as inputs of said differential stage , performing then a binary search to obtain the remaining bits of said digital output value of said second branch .

In variant embodiments said binary search includes
a) setting a value of the output digital value (VDₒᵤₜ in a register and supplying at as input of said digital to analog converter at least a portion of the bits of said value, then
b) setting to a logic value, in particular logic one, or to the other the first most significant bit not already set of said output digital value depending on the output of the comparator, obtaining an approximated output digital value then performing said comparison for each of the bits of said portion,
c) repeating said steps a) and b) for each bit of said at least a portion of the bits of said value in sequence from the most significant,
said value being initially set to correspond to the middle of an input range of said digital to analog converter.

The claims are an integral part of the technical disclosure of the embodiments as provided herein.

### Brief description of the several views in the drawings

One or more embodiments will now be described, by way of example only, with reference to the annexed figures, wherein:
- Figure 1 has been described in the foregoing,
- Figure 2 shows schematically a first embodiment of the analog to digital converter with a single input according to the solution here described,
- Figure 3 shows schematically a second embodiment of the analog to digital converter, with two inputs, according to the solution here described;
- Figure 4 shows schematically a furtherembodiments of the analog to digital converter with two inputs according to the solution here described.

### Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment. Moreover, particular conformations, structures, or characteristics may be combined in any adequate way in one or more embodiments.

The references used herein are provided merely for convenience and hence do not define the extent of protection or the scope of the embodiments.

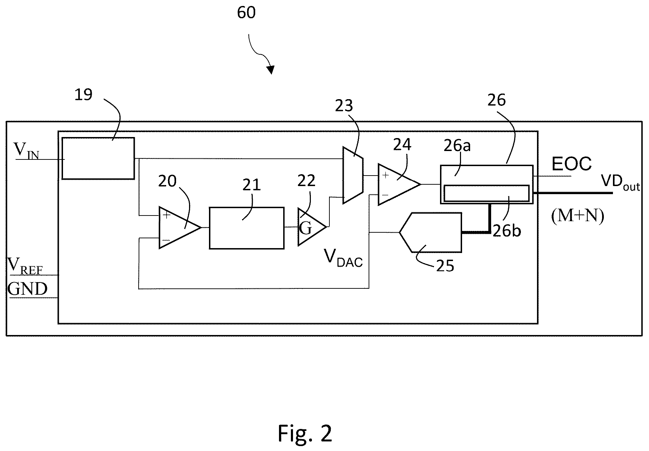

Referring now to figure 2, an embodiment 60 of the Successive Approximation Register Analog-to-Digital Converter, in the following SAR ADC, according to the solution here described is shown in a schematical diagram.

The SAR ADC 60 receives the analog input signal V_{IN}, along with the reference voltage V_{REF} and the ground potential GND. A first sample-and-hold circuit 19 is configured to capture and temporarily hold such input voltage signal V_{IN}. The output of the first sample-and-hold circuit 19 is subsequently applied to an input of a first differential block 20, which computes a differential signal with respect to a signal coming from a DAC 25, described below, substantially operating as a voltage subtractor.

The resulting signal from block 20 is then processed by a second sample-and-hold circuit 21. The output of the second sample-and-hold circuit 21 is then applied to a gain stage 22, which amplifies the signal by a predefined gain factor.

The amplified signal from block 22 is directed to a multiplexer 23. The output of the multiplexer 23 is then forwarded to a second differential block 24, operating as a comparator, where the signal selected by the multiplexer 23 is compared against a reference value generated by the digital-to-analog converter (DAC) 25, which is a N-bit DAC converter which converts the last N bits of the output digital converted value VDₒᵤₜ of (M+N)-bits.

A control logic and data register module 26 receives the output of the second differential block 24 and outputs the output digital converted value VDₒᵤₜ of (M+N) bits. Such control logic and data register module 26 manages the successive approximation process by iteratively adjusting the digital output, i.e., VDₒᵤₜ, until convergence is achieved. As the module 15 in figure 1, it comprises a control logic 26a and a data register 26b, for controlling the operation and for storing the bits of the digital output, i.e., VDₒᵤₜ. Upon completion of the conversion cycle, an End of Conversion signal EOC is generated by the control logic and data register unit 26, indicating that the final digital result is available for retrieval. The digital output VDₒᵤₜ is stored in the binary coded output register 26b during the binary search process, as mentioned, which provides an output format for the output digital converted value VDₒᵤₜ of (M+N) bits, representing the final converted digital value, where N is the resolution of the internal DAC.

Thus, in this embodiment, the analog input voltage V_{IN} is held by the first sample-and-hold circuit 19. In a first phase, the first sample-and-hold circuit 19 output is coupled by the multiplexer MUX 23 to the comparator 24 and the control logic 26a executes the binary search algorithm to determine the first M bits of the code, i.e., current value of the output VDₒᵤₜ, using the N-bits DAC 25, where M is lower than N. Thus, after initializing the MSB at 1, for instance a first value of M bits, setting a mid-range value at the output of the N-bits DAC 25 is set by the control logic 25a, then it is compared in the comparator 24 to the analog input voltage V_{IN}. As mentioned if V_{IN}> V_{DAC} then the MSB bit is maintained at logic 1, else is cleared to logic 0 and then a next cycle is performed by supplying the new binary value thus obtained to the DAC 25. The process is performed iteratively till the last of the M bits is set. Then, in a second phase such M bits are used to set the output of the N-bits DAC 25, which is brought as analog voltage V_{DAC} to the differential stage 20, which operates the difference between V_{IN} and V_{DAC}. The output voltage of the differential stage 20 is held by the second sample-and-hold 21. Then the second sample-and-hold 21 output, through a gain block 22, is then coupled by the multiplexer MUX 23 to the second comparator 24. The gain of block 22 is 2^{M}, i.e., is a multiplication by 2^{M} to perform a scaling. In general M may be equal to N or lower, N being the maximum number of bits that can be identified using the DAC. In general M is lower than N because the ENOB (Effective Number of Bits) of a N-bit ADC is lower than N so for computing the first M bits only the ADC effective bits are used. The control logic 26a executes again in this second phase the binary search algorithm to determine the last N bits of the code using again the N-bits DAC 25. The output binary code VDₒᵤₜ is determined thus using both the M-bits obtained in the first phase and the N-bits obtained in the second phase.

By way of example, assuming N = 4, M = 2, M + N = 6 and V_{IN} / V_{REF} = 0.70, with a 6-bit resolution, the digital result will be 101100b, so such first phase computes the M-bit value 10b, while the second phase computes the N-bit value 1100b and the final digital result will be 10b << 4 + 1100b = 101100b.

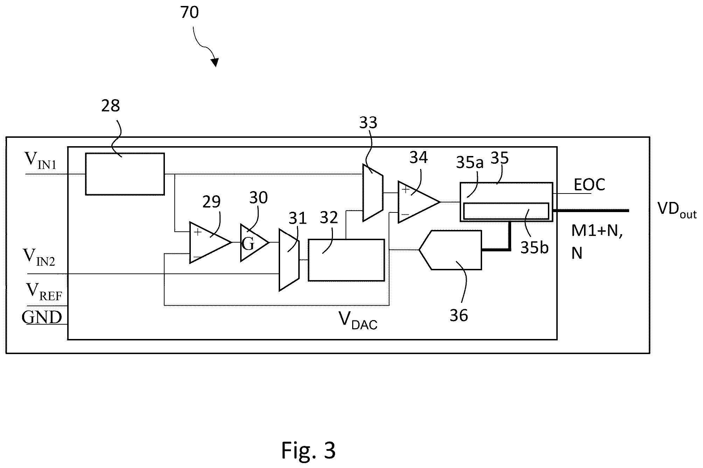

In figure 3 it is shown a block diagram of a Successive Approximation Register Analog-to-Digital Converter (SAR ADC) 70, which operates with a differential input.

The SAR ADC 70 receives thus differential input signals, comprising a first input voltage V_{IN1} and a second input voltage V_{IN2}, and a reference voltage V_{REF}, as well as ground reference GND of the circuit.

The first input voltage V_{IN1} is first processed by a first sample-and-hold circuit 28, which temporarily holds the sampled voltage level. The output of the first sample-and-hold circuit 28 is supplied to a first differential block 29, where it is performed a subtraction with an analog voltage V_{DAC} from a digital-to-analog converter DAC 36 to generate a differential signal.

The resulting differential signal is then amplified by a gain stage 30, which applies a predetermined gain factor. The amplified signal is subsequently fed to a second multiplexer 31, which selects between such signal and the second input voltage V_{IN2} based on the selection signal supplied by the control logic of the architecture, in particular the control logic 26b, as indicated below. The output of the second multiplexer 31 is then directed to a second sample-and-hold circuit 32, where it is temporarily kept in hold before further processing.

Following the second sample-and-hold operation, the signal is routed through a first multiplexer 33, which selects the appropriate input to be processed by a differential amplifier implementing a comparator 34. This comparator 34 compares the signal held at the second sample-and-hold circuit 32 and a feedback signal from the digital-to-analog conversion process, i.e., the analog voltage V_{DAC} from the digital-to-analog converter DAC 36. The resulting comparator output is then supplied to a control logic and data register unit 35, which controls the Successive Approximation process.

The digital-to-analog converter DAC 36 with N bit resolution is coupled to the control logic 35, namely to its data register 35b, which stores the coded digital output VDₒᵤₜ bits, and it is configured for converting the approximated digital values back into analog form, feedback voltage V_{DAC}, for comparison. The system continues iterating through successive approximation cycles, using the binary search, until the conversion is complete. Upon completion, an End of Conversion signal ECOC is generated, and the final digital output VDₒᵤₜ is stored in register 35b as a binary coded value of (M+N)bits or N bits for further processing.

The SAR ADC architecture 70 can operate in two modes of operation.

A first mode of operation allows a single conversion with higher resolution, while a second mode of operation allows a double conversion with regular resolution.

Operating in the first mode, the first analog input voltage V_{IN1} is held by the first sample-and-hold circuit 28. In a first phase of the first mode, the first sample-and-hold 28 output is coupled by the first multiplexer 33 to the comparator 34 and the control logic 35a executes the binary search algorithm to determine first M1 bits of the output code using the N-bits DAC 36, where M1 is lower than N. These M1 bits are used in a second phase to set the output of the N-bits DAC 36 and the output voltage of the voltage subtractor, 29, which is the difference of the first analog input voltage V_{IN1} to the feedback analog voltage V_{DAC}, through a gain block with gain 2^{M1} and the second multiplexer 31 output is held by the second sample-and-hold circuit 32. Then the second sample-and-hold circuit 32 output is coupled by the first multiplexer 33 to the comparator 34. The control logic 35a executes the binary search algorithm to determine the last M2 bits of the code using again the N-bits DAC 35, where M2 is lower than N, or at most equal to N. The output binary code VD_{OUT} is determined using both the M1-bits and the M2-bits. During the execution of the search algorithm for the M2-bits, the hold of a new sample of the input voltages V_{IN1}can start.

Operating in the second mode of operation, the first analog input voltage V_{IN1} is held by the first sample-and-hold circuit 28 and the second analog input voltage V_{IN2} is held, through the second multiplexer 31, by the second sample-and-hold circuit 32. Initially, the first sample-and-hold 28 output is coupled by the first multiplexer 33 to the comparator 34 and the control logic 35a executes the binary search algorithm to determine the N bits of the code representing the first analog input voltage V_{IN1} using the N-bits DAC 35. Then the second sample-and-hold 32 output is then coupled by the first multiplexer 33 to the comparator 34. The control logic 35a executes the binary search algorithm to determine the N bits of the code representing the analog input voltage V_{IN2} using again the N-bits DAC. In this mode the holding of both analog input signals V_{IN1}, V_{IN2} is performed at the same time and the same analog signal can be connected to both inputs.

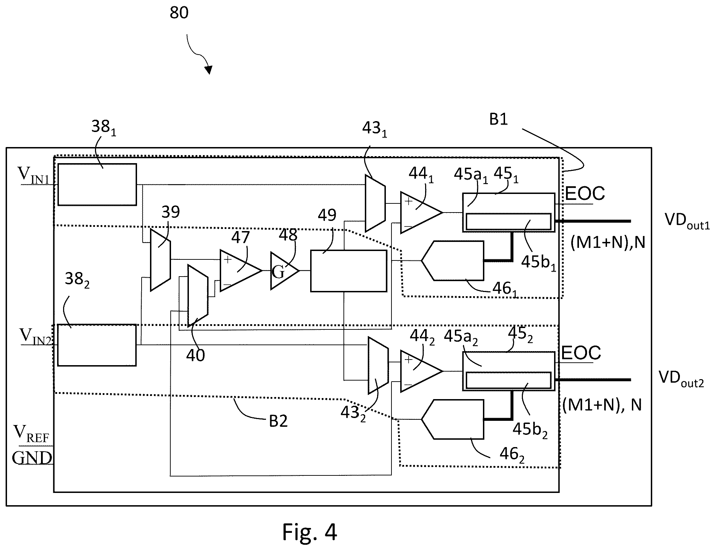

Figure 4 shows a further embodiment 80 of the differential architecture of figure 3. It allows parallel double conversions with regular resolution or partially sequential double conversions with higher resolution because the first M bits of each digitized data are determined in parallel.

Thus, the SAR ADC 80 receives differential input signals, comprising a first input voltage V_{IN1} and a second input voltage V_{IN2}, and a reference voltage V_{REF}. GND indicates the ground reference of the circuit.

The SAR ADC 80 comprises two parallel branches, a first branch B1 receiving the first input voltage V_{IN1} in a first sample-and-hold 38₁ and a second branch B2 receiving the second input voltage V_{IN2} in a second sample-and-hold 38. In the first branch the output of the first sample-and-hold 38₁ is coupled to an input of a first multiplexer 43₁ which output is coupled to an input of a first comparator 44₁. The output of the first comparator 44₁ is fed to a Control logic and data register block 45₁, which outputs the digital output Vdₒᵤₜ, and which register 45b₁ feds a first N-bits DAC 46₁ which output is brought to the other input of comparator 44₁.

In the second branch B2 the output of second sample-and-hold 38₂ is coupled a second multiplexer 43₂ which output is coupled to one input of a second comparator 44₂. The output of the second comparator 44₂ is fed to a Control logic and data register block 45₂, which outputs the digital output Vdₒᵤₜ, and which register 45b₂ feds a second N-bits DAC 46₂ which output is brought to the other input of second comparator 44₂.

Besides such two parallel branches, a third multiplexer 39 receives the outputs of the first sample-and-hold 38₁ and second sample-and-hold 38₂, and feds its selected output to a differential stage 47, operating as voltage subtractor, which through a gain stage 48 feds a third sample-and-hold 49 which output is fed to the other input of the multiplexers 43₁ and 43₂, i.e., the one not couped to the input of the sample-and-hold 38₁ and 38₂ respectively. A fourth multiplexer 40 selects between the outputs of the first and second DAC, 46₁ and 46₂, and feds its selected value to the other input of the differential stage 47.

The first analog input voltage V_{IN1} is held by the first sample-and-hold circuit 38₁ and the second analog input voltage V_{IN2} is held by the second sample-and-hold circuit 38₂. Initially, the first sample-and-hold 38₁ output is coupled by the first multiplexer 43₁ and the second sample-and-hold 38₂ output is coupled by the second multiplexer 43₂ to the respective comparators and the control logic executes the binary search algorithm to determine the first M1 bits of both codes using the respective N-bits DACs, where M1 is lower than N. These M1 bits are used to set the output of the relevant N-bits DACs, then, with the first sample-and-hold 38₁ output and first N-bits DAC 38₁ coupled, the output voltage of the voltage subtractor, through a gain block with gain 2^{M1}, is held by the third sample-and-hold 49, and the third sample-and-hold 49 output is then coupled by the by the first and second multiplexers 43₁ and 43₂ to the relevant second comparators 44₁ and 44₂. The first control logic 45a₁ executes the binary search algorithm to determine the last M2 bits of the first code of the first digital output VDₒᵤₜ₁ using again its N-bits DAC, where M2 is lower than N or at most equal to N. The output binary code is determined using both the M1-bits and the M2-bits. After, with the second sample-and-hold output 38₂ and second N-bits DAC 46₂ connected, the output voltage of the voltage subtractor 47, through a gain block 48 with gain 2^{M1}, is held by the third sample-and-hold 49, and the third sample-and-hold 49 output is then coupled by the first and second multiplexers 43₁ and 43₂ to the relevant second comparators 44₁ and 44₂. The second control logic 45a₁ executes the binary search algorithm to determine the last M2 bits of the second code VDₒᵤₜ₂ using again its N-bits DAC, where M2 is lower than N or at most equal to N. Both the output binary codes VDₒᵤₜ₁ and VDₒᵤₜ₂ are determined using both the relevant M1-bits and the M2-bits.

Thus, in general the proposed solution refers to a Successive Approximation Register Analog to Digital Converter architecture, e.g., 60; 70; 80, comprising at least an input sample and-hold circuit, e.g., 19 or 28, or 38₁, 38₂ with dual input, receiving an analog input voltage, e.g., V_{IN1} or V_{IN1}, V_{IN2}, and a control logic with a data register, e.g. 25; 35; 45₁, 45₂, configured to generate a digital output value, e.g., VDₒᵤₜ; VDₒᵤₜ₁, VDₒᵤₜ₂, with a given maximum bit length, e.g., M+N, or M1+M2, depending on the value of a comparator, e.g., 24; 34; 44₁, 44₂, which input is selectably coupled to said analog input voltage, e.g., V_{IN1}; V_{IN1}, V_{IN2}, through a multiplexer, e.g., 13; 23; 33; 43₁, 43₂, together with an analog output, e.g., V_{DAC}, of a digital to analog converter, e.g., 16; 26; 36; 46₁, 46₂, operating with a number of input bits, e.g. N, lower than said given maximum bit length, e.g., M+N, or M1+M2, which input is set by said a control logic with a data register, e.g., 15; 25; 35; 45₁, 45₂), said architecture, e.g., 50; 60; 70; 80, further comprising a differential stage, e.g., 11; 20; 29; 47, performing a difference between said analog input voltage, e.g., V_{IN1}; V_{IN1}, V_{IN2}, and said analog output, e.g., V_{DAC}, which output is also selectably coupled to said comparator, e.g., 14; 24; 34; 44₁, 44₂, through said multiplexer, e.g., 13; 23; 33; 43₁, 43₂), wherein
a further sample-and-hold circuit, e.g., 21; 32; 49, is interposed between said differential stage, e.g., 20; 29; 47, and said multiplexer, e.g., 13; 23; 33; 43₁, 43₂, said control logic with a data register, e.g., 15; 25; 35; 45₁, 45₂, being configured operate at least in a first operation mode in which couples said comparator, e.g., 24; 34; 44₁, 44₂, in a first phase to said input sample and hold circuit, e.g., 19; 28; 38₁, 38₂, performing a binary search to obtain first most significant bits, e.g., M, of said digital output value, e.g., VDₒᵤₜ, and in a second phase to said further sample-and-hold circuit, e.g., 21; 31, 39, performing a binary search to obtain the remaining bits, e.g., N, of said digital output value, e.g., VDₒᵤₜ; VDₒᵤₜ₁, VDₒᵤₜ₂.

In the embodiment of figure 3, the architecture 70, further receives a first input voltage, e.g., V_{IN1}, in said sample-and-hold circuit, e.g., 29, and a second input voltage, e.g., V_{IN2}, in a second multiplexer, e.g., 31, which also has an input coupled to the output of said differential stage, e.g., 29, selectably coupling its inputs to said further sample-and-hold circuit, e.g., 32, under the control of said control logic with a data register, e.g., 35.

In such architecture, e.g. 70, said control logic with a data register, e.g., 35, is configured to operate in said first operation mode, e.g., like in the embodiment 60, or, alternatively, to operate in a second mode in which couples said comparator, e.g., 34, in a first phase to said input sample and hold circuit, e.g., 19; 28; 38₁, 38₂, performing a binary search to obtain said digital output value, e.g., VDₒᵤₜ, of said first input voltage, e.g., V_{IN1}, with a bit length corresponding to said number of input bits, e.g., N, of said digital to analog converter, e.g., 36, i.e., the number of bits on which the converter operates, and in a second phase couples through said second multiplexer, e.g., 31, said second input voltage, e.g., V_{IN2}, to said comparator, e.g., 34, through said multiplexer, e.g., 33, performing a binary search to obtain said digital output value, e.g., VDₒᵤₜ, of said second input voltage, e.g., V_{IN2} with a bit length, i.e. the number of bits composing the output of the SAR ADC, corresponding to said number of input bits, e.g., N, of said digital to analog converter, e.g., 36.

Then a further variant embodiment 80 with respect to the architecture 50, comprises two parallel branches, e.g., B1, B2, each comprising an input sample and-hold circuit, e.g., 38₁, 38₂, receiving a respective analog input voltage, e.g., V_{IN1}, V_{IN2}, and a control logic with a data register, e.g., 45₁, 45₂, configured to generate a digital output value, e.g., VDₒᵤₜ₁, VDₒᵤₜ₂, depending on the value of a respective comparator, e.g., 44₁, 44₂, which input is selectably coupled to said respective analog input voltage, e.g., V_{IN1}, V_{IN2}, through a respective multiplexer, e.g., 43₁, 43₂, together with an analog output, e.g., V_{DAC1}, V_{DAC2}, of a respective digital to analog converter, e.g., 46₁, 46₂, which input is set by said respective control logic with a data register, e.g., 45₁, 45₂,
said architecture further comprising a third multiplexer, e.g., 39, receiving the outputs of the sample-and-hold, e.g., 38₁, of said first branch, e.g., B1, and sample-and-hold , e.g., 38₂, of said second branch, e.g., B2, which output is coupled to said differential stage, e.g., 47, operating as voltage subtractor, which through a gain stage 48 feeds a third sample-and-hold 49 which output is fed to another input of the multiplexers, e.g., 43₁, 43₂, of the first branch, e.g., B1, and second branch, e.g., B2), and a fourth multiplexer, e.g., 40, selecting between the outputs of the digital to analog converter, e.g., 46₁, 46₂, of the first branch, e.g., B1, and second branch, e.g., B2, respectively, and feeding its selected value to the other input of the differential stage, e.g., 49).

The operation of said architecture 80 provides that the respective control logic with a data register modules, e.g., 45₁, 45₂, are configured to operate in said first phase of said first mode of operation in parallel to determine respective first most significant bits, e.g., M, of said respective digital output value, e.g., VDₒᵤₜ₁, VDₒᵤₜ₂, at the output of said first branch, e.g., B1, and second branch, e.g., B2), then in said second phase, in which said third multiplexer, e.g., 39, and fourth multiplexer, e.g., 40, selects first said first input voltage, e.g., V_{IN1}, and analog output, e.g., V_{DAC1}, of the digital to analog converter, e.g., 46₁, of the first branch, e.g., B1, as inputs of said differential stage, e.g., 39, then performing a binary search to obtain the remaining bits, e.g., N, of said digital output value, e.g., VDₒᵤₜ₁, of said first branch, e.g., B1, then said third multiplexer, e.g., 39, and fourth multiplexer, e.g., 40, selects second input voltage, e.g., V_{IN2}, and analog output, e.g., V_{DAC2}, of the digital to analog converter, e.g., 46₂, of the second branch, e.g., B2, as inputs of said differential stage, e.g., 39), then performing a binary search to obtain the remaining bits, e.g., N, of said digital output value, e.g., VDₒᵤₜ₂, of said second branch, e.g., B1.

In this underlined that said digital to analog converter, e.g., 26; 36; 46₁, 46₂, operates with a number of bits equal to the number N of said less significant bits, i.e., the DAC operates with a number of bits N which is lower than the total bit length of the digital output, e.g. M+N, or M1+M2, and a gain stage, e.g., 30 or 22 or 48, is coupled to the differential stage, e.g., 20; 29; 47, and the multiplexer , e.g., 23; 33; 43₁, 43₂, which has a gain of two to the power of the number of said most significant bits, e.g. M, M1, to perform the scaling of the analog value in the phase when the less significant bits are converted. The gain stage may be placed downstream the output of the second sample and hold 21 (gain stage 22) or at the output of the differential stage 29, 47 before the second sample and hold 32 (gain stage 30) or the third sample and hold 49 (which functionally corresponds to the second sample and hold of figures 2 and 3), i.e. as gain stage 48.

The binary search performed includes
a) setting a value of the output digital value, VDₒᵤₜ, in a register, e.g. 25b or 35b, in particular in the module 25, and supplying at as input of said digital to analog converter, e.g., 26 or 36, at least a portion, which for instance may correspond in the first mode of operation to the M of significant bits in the first phase and then the remaining bits N in the second phase, while where a normal resolution is attained said at least a portion may correspond to the whole N bits of output digital value, then
b) setting to a logic value, in particular logic one, or to the other, e.g., logic zero, the first most significant bit not already set of said output digital value, VDₒᵤₜ, depending on the output of the comparator 24, in particular if the output of the DAC is respectively lower or not with respect to the signal at the other input of the comparator 24, obtaining an approximated output digital value VDₒᵤₜ, i.e., approximated since only part of the most significant bits taken in order is set, then performing said comparison for each of the bits of said portion, e.g. M or N, or M1 or M2,
c) repeating said steps a) and b) for each bit of said at least a portion, e.g. M or N, of the bits of said value in sequence from the most significant,
said value being initially, i.e. in the first of the iteration of operation a), set to correspond to the middle of an input range of said digital to analog converter, e.g. 26, for instance to a digital value corresponding to V_{REF}/2, if the reference voltage V_{REF} sets the range amplitude (i.e. from zero to V_{REF}).

Thus, from the above description the advantages of the proposed solution are apparent.

The proposed solution thus replaces the one of the DAC of figure 1 with a S&H circuit. The area of the S&H circuit and the area of the DAC depend on the specific design and implementation, but the area of the S&H circuit is usually a small fraction of the overall ADC area, and it is typically much smaller than the area of the DAC. Moreover, the area of a S&H circuit depends on the voltage range of the input signal. In general, if the voltage range of the input signal is wider, the S&H circuit may need to be designed with larger capacitors and/or higher voltage transistors to handle the larger voltage swing. As result, the area of the second S&H circuit 21 is also smaller than the area of the first S&H circuit 19. The area of the Sample and Hold (S&H) circuit in a 3.3V 12-bit SAR ADC implemented in a 40nm CMOS technology would typically be in the range of 0.01 to 0.1 square millimetres, depending on the specific design and implementation. This corresponds to approximately 1% to 10% of the total ADC area. The area of the Digital-to-Analog Converter (DAC) in a 3.3V 12-bit SAR ADC implemented in a 40nm CMOS technology would typically be in the range of 0.1 to 1 square millimetres, depending on the specific design and implementation. This corresponds to approximately 10% to 100% of the total ADC area, with the DAC being the largest contributor to the total area. It's important to note that the exact percentage of the area occupied by the S&H and DAC circuits in a 3.3V 12-bit SAR ADC implemented in a 40nm CMOS technology depends on the specific design requirements, such as the resolution, speed, power consumption, and cost, as well as the manufacturing process and foundry used. Finally the benefit of the proposed solution is to increase the resolution of an ADC without excessively increasing its complexity or its processing time.

From the description here above thus the advantages of the solution described are clear.

Advantageously, thus the solution described increases the resolution of a SAR ADC without excessively increasing its complexity or its processing time.

The proposed solution in particular uses sample-and-hold circuits in place of further DACs, e.g. in place of the further DAC of the two step SAR-DAC shown in figure 1. The area of the sample-and-hold circuit and the area of the DAC depend on the specific design and implementation, but the area of the sample-and-hold circuit is usually a small fraction of the overall ADC area, and it is typically much smaller than the area of the DAC.

Moreover, the area of a sample-and-hold circuit depends on the voltage range of the input signal. In general, if the voltage range of the input signal is wider, the sample-and-hold circuit may need to be designed with larger capacitors and/or higher voltage transistors to handle the larger voltage swing. As result, the area of the further sample-and-hold circuits is also smaller than the area of the input sample-and-hold circuit (or circuits in the case of two inputs like in the embodiment of figures 3 and 4).

The solution in embodiment also allows two conversions of the same analog signal at the same time for functional safety purposes.

In embodiments the solution with two parallel branches, e.g., figure 4, is more efficient than the simple duplication of the ADC.

Without prejudice to the underlying principles, the details and embodiments may vary, even significantly, with respect to what has been described by way of example only, without departing from the extent of protection.

The extent of protection is defined by the annexed claims.

## Claims

1. A Successive Approximation Register Analog to Digital Converter architecture (50; 60; 70; 80) comprising
at least an input sample and-hold circuit (10; 19; 28; 38₁, 38₂) receiving an analog input voltage (V_{IN1}; V_{IN1}, V_{IN2}) and
a control logic with a data register (15; 25; 35; 45₁, 45₂) configured to generate a digital output value (VDₒᵤₜ; VDₒᵤₜ₁, VDₒᵤₜ₂) with a given maximum bit length (M+N; M1+M2) depending on the value of a comparator (14; 24; 34; 44₁, 44₂) which input is selectably coupled to said analog input voltage (V_{IN1}; V_{IN1}, V_{IN2}) through a multiplexer (13; 23; 33; 43₁, 43₂) together with an analog output (V_{DAC}) of a digital to analog converter (16; 26; 36; 46₁, 46₂) operating with a number of input bits (N) lower than said given maximum bit length (M+N; M1+M2), which input is set by said control logic with a data register (15; 25; 35; 45₁, 45₂), said architecture (50; 60; 70; 80) further comprising a differential stage (11; 20; 29; 47) performing a difference between said analog input voltage (V_{IN1}; V_{IN1}, V_{IN2}) and said analog output (V_{DAC}) which output is also selectably coupled to said comparator (14; 24; 34; 44₁, 44₂) through said multiplexer (13; 23; 33; 43₁, 43₂), wherein
a further sample-and-hold circuit (21; 32; 49) is interposed between said differential stage (20; 29; 47) and said multiplexer (13; 23; 33; 43₁, 43₂), said control logic with a data register (15; 25; 35; 45₁, 45₂) being configured to operate at least in a first operation mode in which couples said comparator (24; 34; 44₁, 44₂)
in a first phase to said input sample and hold circuit (19; 28; 38₁, 38₂) performing a binary search to obtain first most significant bits (M; M1) of said digital output value (VDₒᵤₜ), and
in a second phase to said further sample-and-hold circuit (21; 31, 39) performing a binary search to obtain the remaining bits (N; M2) of said digital output value (VDₒᵤₜ; VDₒᵤₜ₁, VDₒᵤₜ₂).

2. A Successive Approximation Register Analog to Digital Converter architecture (70) according to claim 1, wherein said architecture receives a first input voltage (V_{IN1}) in said sample-and-hold circuit (29) and a second input voltage (V_{IN2}) in a second multiplexer (31), which also has an input coupled to the output of said differential stage (29) selectably coupling its inputs to said further sample-and-hold circuit (32) under the control of said control logic with a data register (35).

3. A Successive Approximation Register Analog to Digital Converter architecture (70) according to claim 2, wherein said control logic with a data register (35) is configured to operate in said first operation mode, maintaining selected the output of said differential stage (2) through said second multiplexer (31), or to operate in a second mode in which
in a first phase couples said comparator (34) to said input sample and hold circuit (28) performing a binary search to obtain said digital output value (VDₒᵤₜ) of said first input voltage (V_{IN1}) with a bit length corresponding to said number of input bits (N) of said digital to analog converter (36), and
in a second phase couples through said second multiplexer (31) said second input voltage (V_{IN2}) to said comparator (34) through said multiplexer (33) performing a binary search to obtain said digital output value (VDₒᵤₜ) of said second input voltage (V_{IN2}) with a bit length corresponding to said number of input bits (N) of said digital to analog converter (36).

4. A Successive Approximation Register Analog to Digital Converter architecture (80) according to claim 1, wherein said architecture (80) comprises two parallel branches (B1, B2), each comprising an input sample and-hold circuit (38₁, 38₂) receiving a respective analog input voltage (V_{IN1}, V_{IN2}) , and a control logic with a data register (45₁, 45₂) configured to generate a digital output value (VDₒᵤₜ₁, VDₒᵤₜ₂) depending on the value of a respective comparator (44₁, 44₂) which input is selectably coupled to said respective analog input voltage (V_{IN1}, V_{IN2}) through a respective multiplexer (43₁, 43₂) together with an analog output (V_{DAC1}, V_{DAC2}) of a respective digital to analog converter (46₁, 46₂) which input is set by said respective control logic with a data register (45₁, 45₂),
said architecture (80) further comprising a third multiplexer (39) receiving the outputs of the sample-and-hold (38₁) of said first branch (B1) and sample-and-hold (38₂) of said second branch (B2) which output is coupled to said differential stage (47) operating as voltage subtractor, which through a gain stage 48 feeds a third sample-and-hold 49 which output is fed to another input of the multiplexers (43₁, 43₂) of the first branch (B1) and second branch (B2), and a fourth multiplexer (40) selecting between the outputs of the digital to analog converter (46₁, 46₂) of the first branch (B1) and second branch (B2) respectively and feeding its selected value to the other input of the differential stage (49).

5. A Successive Approximation Register Analog to Digital Converter architecture (50; 60; 70; 80) according to claim 4, wherein said respective control logic with a data register (45₁, 45₂) are configured to operate in said first phase of said first mode of operation in parallel to determine respective first most significant bits (M1) of said respective digital output value (VDₒᵤₜ₁, VDₒᵤₜ₂) at the output of said first branch (B1) and second branch (B2), then in said second phase, in which said third multiplexer (39) and fourth multiplexer (40) selects first said first input voltage (V_{IN1}) and analog output (V_{DAC1}) of the digital to analog converter (46₁) of the first branch (B1)) as inputs of said differential stage (39), then performing a binary search to obtain the remaining bits (M2) of said digital output value (VDₒᵤₜ₁) of said first branch (B1), then said third multiplexer (39) and fourth multiplexer (40) selects second input voltage (V_{IN2}) and analog output (V_{DAC2}) of the digital to analog converter (46₂) of the second branch (B2) as inputs of said differential stage (39), then performing a binary search to obtain the remaining bits (N; M2) of said digital output value (VDₒᵤₜ₂) of said second branch (B1).

6. A Successive Approximation Register Analog to Digital Converter architecture (60; 70; 80) according to claim 1, wherein said digital to analog converter (26; 36; 46₁, 46₂) operates with a number of bits equal to the number (N) of said less significant bits and a gain stage (G) is coupled to said differential stage (20; 29; 47) and said multiplexer (23; 33; 43₁, 43₂), which has a gain of two to the power of the number of said most significant bits (M; M1).

7. A method for performing Successive Approximation Register Analog to Digital conversion with the architecture (60; 70; 80) of any of claims 1 to 6, comprising at least a first mode of operation comprising a first phase comprising coupling said comparator (24; 34; 44₁, 44₂) to said input sample and hold circuit (19; 28; 38₁, 38₂) performing a binary search to obtain first most significant bits (M; M1) of said digital output value (VDₒᵤₜ) and in a second phase to said further sample-and-hold circuit (21; 31, 39) performing a binary search to obtain the remaining bits (N; M2) of said digital output value (VDₒᵤₜ; VDₒᵤₜ₁, VDₒᵤₜ₂).

8. The method for performing Successive Approximation Register Analog to Digital conversion with the architecture (60; 70; 80) of claim 2, comprising operating in said first operation mode or to operate in a second mode comprising coupling said comparator (34) in a first phase to said input sample and hold circuit (28; 38₁, 38₂) performing a binary search to obtain said digital output value (VDₒᵤₜ) of said first input voltage (V_{IN1}) with a bit length corresponding to said number of input bits (N) of said digital to analog converter (36) and in a second phase comprising coupling through said second multiplexer (31) said second input voltage (V_{IN2}) to said comparator (34) through said multiplexer (33) performing a binary search to obtain said digital output value (VDₒᵤₜ) of said second input voltage (V_{IN2}) with a bit length corresponding to said number of input bits (N) of said digital to analog converter (36).

9. The method for performing Successive Approximation Register Analog to Digital conversion with the architecture (60; 70; 80) of claim 4, comprising operating in said first phase of said first mode of operation in parallel to determine respective first most significant bits (M) of said respective digital output value (VDₒᵤₜ₁, VDₒᵤₜ₂) at the output of said first branch (B1) and second branch (B2), then in said second phase of said first mode of operation by selecting through said third multiplexer (39) and fourth multiplexer (40) first said first input voltage (V_{IN1}) and analog output (V_{DAC1}) of the digital to analog converter (46₁) of the first branch (B1)) as inputs of said differential stage (39), performing then a binary search to obtain the remaining bits (N) of said digital output value (VDₒᵤₜ₁) of said first branch (B1), then selecting through said third multiplexer (39) and fourth multiplexer (40) the second input voltage (V_{IN2}) and analog output (V_{DAC2}) of the digital to analog converter (46₂) of the second branch (B2) as inputs of said differential stage (39), performing then a binary search to obtain the remaining bits (N) of said digital output value (VDₒᵤₜ₂) of said second branch (B1).

10. The method for performing Successive Approximation Register Analog to Digital conversion with the architecture (60; 70; 80) of any of claims 7 to 9, wherein said binary search includes
a) setting a value of the output digital value (VDₒᵤₜ in a register (25b) and supplying at as input of said digital to analog converter (26) at least a portion (M) of the bits of said value, then
b) setting to a logic value, in particular logic one, or to the other the first most significant bit not already set of said output digital value (VDₒᵤₜ) depending on the output of the comparator (24), obtaining an approximated output digital value (VDₒᵤₜ)then performing said comparison for each of the bits of said portion (M),
c) repeating said steps a) and b) for each bit of said at least a portion (M) of the bits of said value in sequence from the most significant,
said value being initially set to correspond to the middle of an input range of said digital to analog converter (26).
